(19) Europäisches Patentamt
European Patent Office
Office européen des brevets

(11) Veröffentlichungsnummer: **0 127 574**
**B1**

(12) # EUROPÄISCHE PATENTSCHRIFT

(45) Veröffentlichungstag der Patentschrift: **07.10.87**

(51) Int. Cl.[4]: **G 03 F 7/10**, G 03 C 1/68

(21) Anmeldenummer: **84810195.2**

(22) Anmeldetag: **24.04.84**

(54) **Lichtvernetzbare Stoffgemische.**

(30) Priorität: **26.04.83 GB 8311252**

(43) Veröffentlichungstag der Anmeldung: **05.12.84 Patentblatt 84/49**

(45) Bekanntmachung des Hinweises auf die Patenterteilung: **07.10.87 Patentblatt 87/41**

(84) Benannte Vertragsstaaten: **BE CH DE FR GB IT LI NL SE**

(56) Entgegenhaltungen:
**EP - A - 0 062 610**

**CHEMICAL ABSTRACTS, Band 73, 1970, Seite 35, Nr. 15719x, Columbus, Ohio, US**

(73) Patentinhaber: **CIBA-GEIGY AG, Klybeckstrasse 141, CH-4002 Basel (CH)**

(72) Erfinder: **Irving, Edward, Dr., 41, Swaffham Road, Burwell Cambridge CB5 0AN (GB)**

**EP 0 127 574 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Stoffgemische, die ein lichtvernetzbares Material und einen Elektronenakzeptor enthalten, ein Verfahren zum Vernetzen dieser Stoffgemische, deren Verwendung zur Bilderzeugung sowie die Verwendung der vernetzten Materialien als Oberflächenbeschichtungsmaterialien und Klebstoffe sowie zur Herstellung von verstärkten Verbundwerkstoffen, gedruckten Schaltungen und Druckplatten.

Lichtvernetzbare Materialien, welche durch Cycloadditionsreaktionen vernetzen, sind bekannt und mehrere davon sind im Handel erhältlich. Materialien, die auf diese Weise vernetzen, enthalten z.B. Chalkone oder Malein- oder Dimethylmaleinsäureimide. Sie sind in «Photocrosslinkable Resin Systems» [(Green, Stark und Zahir, J. Macro. Sci. Revs. Macro. Chem., C21(2) 219–234 (1981–82)] eingehend beschrieben. Obwohl diese Materialien mit Erfolg industriell angewendet werden, erfolgt deren Vernetzung bei gewissen Anwendungen etwas langsam, so dass Mittel zur Erhöhung der Vernetzungsgeschwindigkeit benötigt werden.

Es wurde gefunden, dass dies durch Zusatz bestimmter aromatischer und chinon-artiger organischer Elektronenakzeptoren zu dem lichtvernetzbaren Material erreicht werden kann.

In der JP-A-54-95688 (1979) (Derwent CPI Abstract Nr. 65588B) werden photopolymerisierbare Stoffgemische beschrieben, die

(A) eine äthylenisch ungesättigte Verbindung und

(B) ein Zweikomponenten-Initiatorsystem enthalten, das seinerseits

(i) eine Verbindung der Formel $Y-CH=CHCOR^3$, $Y-CH=CHCO-p-C_6H_4-X$, $Y-CH=CHCOCH=CH-p-C_6H_4-X$, $Y-CO-p-C_6H_4-X$, $Y-CH(OH)COPh$, $Y-CH=CHSO_2R^3$, $Y-CHO$ oder der Formel

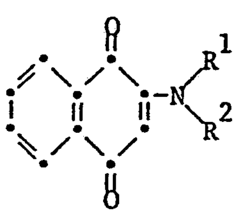

oder

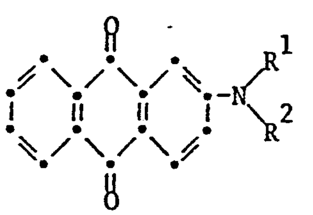

,

worin $R^1$ und $R^2$ Alkyl, $R^3$ Alkyl, Alkoxy, Aryl oder Aryloxy, X Wasserstoff, Alkoxy, Alkylcarbonyl, Alkylcarbonyloxy, Alkyl(carbonyl)amino, Alkyl(carbonyl)thio, Alkylsulfinyl, Alkylsulfonyl, Aryloxy, Aralkyl, Carboxyl, Amino, Aminosulfonyl, Thiocyano, Mercapto, $PO_3H$, $SO_3H$, Hydroxyl oder Halogen und Y einen Rest $R^1R^2N-p-C_6H_4-$ bedeuten, und

(ii) eine Verbindung der Formel $A-C_6H_4CN$, $NC-p-C_6H_4-CH=CHCO-p-C_6H_4-E$, $G-C_6H_4-CH=C(CN)_2$ oder $G-C_6H_4-CH=C(CN)COOR^4$, Monocyannaphthalin oder 1,1-Dicyan-2-naphthyläthen enthält, wobei A Wasserstoff, CN, Formyl, Carboxyl, Dialkylamino oder Alkoxy, E Wasserstoff, Halogen, Alkyl, Hydroxyl oder CN, G Wasserstoff, CN oder Dialkylamino und $R^4$ Alkyl, Aryl oder Aralkyl darstellen.

Als photopolymerisierbare Verbindungen (A) sind in der genannten Offenlegungsschrift nur Acrylate und Methacrylate erwähnt. Die als Initiatoren unter (B) (i) beschriebenen Chalkone sind nicht lichtvernetzbar, da sie nur einen Chalkonrest enthalten. Diese Offenlegungsschrift beschreibt daher die Verwendung eines Gemisches aus einem nicht-vernetzbaren Chalkon (i) und einer Cyanverbindung (ii) als Initiatoren für die Photopolymerisation von Acrylaten und Methacrylaten. Es ist kein Hinweis darauf zu finden, dass die Cyanverbindungen zum Beschleunigen der Vernetzung von lichtvernetzbaren Chalkonen oder Maleinimiden verwendet werden könnten.

Gegenstand der Erfindung sind daher lichtvernetzbare Stoffgemische, enthaltend

(a) ein ungesättigtes lichtvernetzbares Material, das entweder eine Gruppe der Formel I

$$Ar-CH=CR-CO- \quad (I),$$

die über die angegebene Carbonylgruppe an ein C-Atom gebunden ist, d.h. eine chalkon-ähnliche Gruppe, oder eine Gruppe der Formel II

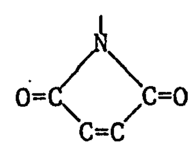

(II),

d.h. ein cyclisches Imid, aufweist, worin

Ar eine ein-, zwei- oder dreiwertige aromatisch-carbocyclische oder aromatisch-heterocyclische Gruppe und

R ein Wasserstoffatom, eine Alkylgruppe mit 1-4 C-Atomen oder eine Gruppe darstellen, die zusammen mit dem Bindungs-C-Atom und der angegebenen Carbonylgruppe einen 5-, 6- oder 7-gliedrigen carbocyclischen oder heterocyclischen Ring bildet, und

(b) eine wirksame Menge eines organischen Elektronenakzeptors der Formel III oder IV

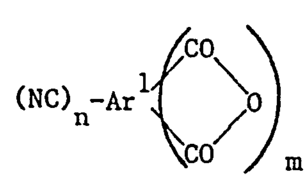

oder (III)

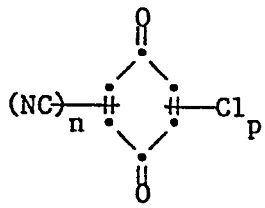

(IV),

worin

$Ar^1$ eine (2m+n)-wertige carbocyclisch-aromatische Gruppe darstellt, die durch 1 bis 4 Alkylgruppen mit 1–4 C-Atomen, Halogenatome und/oder Nitrogruppen substituiert sein kann,

n = Null oder 1 bis 4 bedeutet

m = Null, 1 oder 2 darstellt, wobei, wenn m 2 ist, n = Null darstellt, wenn m = 1 ist, n = 1 oder 2 darstellt und wenn m = Null ist, n = 2, 3 oder 4 darstellt und wobei die angegebenen Anhydridcarbonylgruppen an benachbarte C-Atome eines aromatischen Ringes gebunden sind, und p = Null, 2 oder 4 darstellt, wobei die Summe von (n+p) = vier ist.

Gegenstand der Erfindung ist auch ein Verfahren zur Herstellung von lichtvernetzten Produkten, indem man ein die Komponenten (a) und (b) enthaltendes Gemisch herstellt und das Gemisch bis zur Vernetzung mit aktinischem Licht bestrahlt, sowie die nach diesem Verfahren erhaltenen vernetzten Produkte.

Die aromatischen Gruppen $Ar^1$ sind bevorzugt monocyclische oder kondensierte polycyclische Gruppen oder Diarylengruppen, in denen die beiden Arylengruppen, die je monocyclisch oder kondensiert polycyclisch sein können, über eine kovalente Bindung, ein Sauerstoffatom, eine Carbonyl-, Sulfonyl- oder Alkylengruppe mit 1–6 C-Atomen miteinander verknüpft sind. Besonders bevorzugt ist die Gruppe $Ar^1$ unsubstituiert.

Als Elektronenakzeptoren der Formel III sind solche bevorzugt, worin $Ar^1$ ein Benzolring, ein Naphthalinring, eine Diphenylengruppe oder eine Benzophenongruppe ist. Als Elektronenakzeptoren der Formel IV werden diejenigen bevorzugt, worin p 2 oder 4 darstellt.

Besonders bevorzugte Elektronenakzeptoren, die erfindungsgemäss eingesetzt werden können, sind 2,3-Dichlor-5,6-dicyanbenzochinon, 1,2-, 1,3- und 1,4-Dicyanbenzol, 3,4,3′,4′-Benzophenontetracarbonsäuredianhydrid, Pyromellitsäuredianhydrid, Chloranil, d.h. 2,3,5,6-Tetrachlorbenzochinon, und 1,2,4,5-Tetracyanbenzol.

Bekanntlich müssen bei der Formulierung von lichtvernetzbaren Stoffgemischen Komponenten gewählt werden, welche Licht nicht bei derselben Frequenz wie die eingesetzen lichtvernetzbaren Harze absorbieren. Es muss daher darauf geachtet werden, dass der Elektronenakzeptor in dieser Beziehung mit dem verwendeten Chalkon oder cyclischen Imid verträglich ist. Geeignete verträgliche Materialien können von dem Fachmann auf dem Gebiet der Formulierungstechnik leicht ermittelt werden.

Besonders bevorzugte lichtvernetzbare Materialien sind solche mit Gruppen der Formel I, worin Ar einen ein- oder zweiwertigen, mono- oder bicyclischen aromatischen Kohlenwasserstoffrest mit 6–10 C-Atomen oder eine mono- oder bicyclische aromatisch-heterocyclische Gruppe mit 4–9 C-Atomen und R ein Wasserstoffatom darstellen, oder Materialien mit Gruppen der Formel II, worin die äthylenischen C-Atome direkt an Wasserstoff- oder Halogenatome oder an Alkylgruppen mit 1–4 C-Atomen, Cyan- oder Phenylgruppen gebunden sind. Das cyclische Imid der Formel II ist bevorzugt Bestandteil einer Maleinimidstruktur, wie z.B. eines α-Phenylmaleinimids oder eines Dimethylmaleinimids.

Die genannten chalkon-artigen Gruppen oder Maleinimidgruppen können als seitenständige Gruppen vorliegen oder Bestandteil einer Polymerkette bilden, sofern sie mindestens zweiwertig sind.

Als Maleinimide eignen sich im allgemeinen Polymere mit seitenständigen Maleinimideinheiten. Beispiele solcher Polymere sind Materialien mit seitenständigen α-Arylmaleinimideinheiten, die z.B. durch Umsetzung eines α-Arylmaleinsäureanhydrids mit einem Styrol- oder p-Aminostyrolpolymeren hergestellt werden, Materialien mit seitenständigen Dimethylmaleinimideinheiten, die z.B. durch Behandlung eines Methylvinyläther-Maleinsäureanhydridcopolymeren mit einem N-(Hydroxycycloalkyl)dimethylmaleinimid oder durch Polymerisation oder Copolymerisation der Acrylate oder Methacrylate von N-(Hydroxyalkyl)dimethylmaleinimiden erhalten werden, sowie die Umsetzungsprodukte aus N-Chlormethylmaleinimiden mit Polystyrol. Andere geeignete maleinimidhaltige Materialien sind beispielsweise die Umsetzungsprodukte von Maleinimid, Formaldehyd und Toluol und die Reaktionsprodukte aus Epoxidharzen mit verschiedenen α-Arylmaleinimidderivaten.

Seitenständige chalkon-artige Gruppen können nach verschiedenen an sich bekannten Methoden in Polymere eingeführt werden, wie z.B. durch Kondensation von Polyvinylacetophenon mit Benzaldehyd, durch Friedel-Crafts-Reaktion von Polystyrol mit Zimtsäurechlorid, durch Addition von p-Isocyanatobenzalacetophenon an Polyvinylalkohol oder durch Umsetzung von Styrol-Maleinsäureanhydrid-Copolymeren mit 4-Methoxy-4′-(2-hydroxyäthoxy)chalkon.

Chalkon-artige Gruppen können in die Hauptkette des Polymers z.B. durch Kondensation eines hydroxylsubstituierten Benzaldehyds, wie z.B. p-Hydroxybenzaldehyd, mit verschiedenen Ketonen, wie z.B. Aceton oder Cyclopentanon, eingebaut werden, wobei lichtempfindliche Bisphenole mit chalkon-artigen Gruppen entstehen. Diese Bisphenole können zur Herstellung von Epoxidharzen, Polycarbonaten, Polyestern, Polysulfonen oder Polyphosphonaten verwendet werden.

Die Herstellung der genannten lichtvernetzbaren Materialien ist in dem oben zitierten Artikel von Green, Stark und Zahir beschrieben. Diese Materialien können selbstverständlich pro Durchschnittsmolekül mehr als eine Maleinimid- oder Chalkongruppe enthalten.

Verbindungen, die eine oder mehrere Maleinimidgruppen und eine Acrylat- oder Methacrylatgruppe enthalten, können zusammen mit einem Photopolymerisations-Initiator für acrylgruppenhaltige Materialien direkt in den erfindungsgemässen Stoffgemischen eingesetzt werden. Durch die Photopolymerisation solcher Verbindungen über die Acrylgruppe entsteht ein Polymer mit Maleinimidgruppen, über die das Polymer dann vernetzt wird. Geeignete Verbindungen dieser Art sind die Acrylate und Methacrylate von N-(Hydroxyalkyl)dimethylmaleinimiden. Als Photopolymerisations-Initiatoren für acrylgruppenhaltige Materialien kommen z.B. organische Peroxide und Hydroperoxide, α-halogensubstituierte Acetophenone, Benzoin und dessen Alkyläther, α-Methylbenzoin, Benzophenone, Benzilketale, vor allem Benzildimethylketal, substituierte Thioxanthone, wie z.B. 2-Chlorthioxanthon und 2-Isopropylthioxanthon, und Anthrachinone in Betracht.

Als lichtvernetzbare Materialien werden Epoxidharze mit durchschnittlich mehr als einer Gruppe der Formel I bevorzugt, insbesondere Materialien, die durch Vorverlängerung von Polyglycidyläther von mehrwertigen Phenolen oder Diglycidylhydantoinen mit einem eine Gruppe der Formel I enthaltenden Bisphenol erhalten werden.

Besonders bevorzugt sind Diglycidyläther von Bisphenol A [2,2-Bis(4-glycidyloxyphenyl)-propan] oder 1,3-Diglycidyl-5,5-dimethylhydantoin, die mit 1,4-Bis[3-(4-hydroxyphenyl)-3-oxo-1-propenyl]benzol vorverlängert sind. Weitere bevorzugte lichtvernetzbare Materialien sind N-(2-Methacryloyloxyäthyl)-2,3-dimethylmaleinimid oder die entsprechende Acryloyloxyverbindung (zusammen mit einem dafür geeigneten Photopolymerisations-Initiator), Homopolymere dieser Verbindungen oder Copolymere davon mit Vinylmonomeren, wie z.B. Aethylacrylat, Methylmethacrylat, Acrylsäure, Methacrylsäure und Styrol.

Die lichtvernetzbaren Materialien können gewünschtenfalls nach an sich bekannten Methoden in verdünntem wässrigem Alkali löslich oder dispergierbar gemacht werden. So können z.B. durch Verwendung von Acrylsäure oder Methacrylsäure als Comonomer-Ausgangsprodukt bei der Herstellung der vernetzbaren Materialien aus additions-polymerisierbaren Monomeren saure Gruppen in das Molekül eingebaut werden.

Die Menge des organischen Elektronenakzeptors (b) in dem erfindungsgemässen Stoffgemisch ist nicht kritisch, solange damit eine ausreichende beschleunigende Wirkung erzielt wird. Die Menge kann je nach den Erfordernissen des Verbrauchers und der Art des eingesetzten lichtvernetzbaren Materials (a) und des Elektronenakzeptors (b) varriiren. Im allgemeinem liegt der Elektronenakzeptor in einer Menge von 0,1 bis 6 Gew.%, bezogen auf das Gewicht des lichtvernetzbaren Materials, vor. Besonders bevorzugt sind Mengen von 0,4 bis 4 Gew.%, bezogen auf das Gewicht des lichtvernetzbaren Materials.

Die Stoffgemische können auch bekannte Sensibilisatoren für die Lichtvernetzung von chalkon- oder maleinimidgruppenhaltigen Materialien enthalten, z.B. Bis(dialkylamino)-benzophenone, wie Michler's Keton, und Thioxanthone, z.B. 2-Chlorthioxanthon und Thioxanthon-1-carbon-säuremethylester.

Im erfindungsgemässen Verfahren wird zweckmässig aktinisches Licht mit einer Wellenlänge von 200 bis 600 nm eingesetzt. Als Lichtquellen kommen z.B. Kohlelichtbögen, Quecksilberdampfbögen, fluoreszierende Lampen mit ultraviolettes Licht ausstrahlenden Phosphoren, Argon- und Xenonglühlampen, Wolframlampen und photographische Flutlichtlampen in Betracht. Besonders geeignet sind Quecksilberdampfbögen, besonders Sonnenlampen, fluoreszierende Sonnenlampen und Metallhalogenidlampen. Die benötigte Belichtungszeit für ein spezifisches Harz hängt von mehreren Faktoren ab, wie z. B. der Art des eingesetzten Harzes, der Dicke der Beschichtung, der Art der Lichtquelle und deren Abstand von der Beschichtung. Sie kann jedoch leicht durch Routineversuche ermittelt werden.

Die erfindungsgemässen Stoffgemische eignen sich vor allem zur Bilderzeugung, indem man die Stoffgemische bildmässig mit aktinischem Licht bestrahlt. Die bildmässige Belichtung kann durch ein transparentes, ein Bild aufweisendes Material oder mit einem computergesteuerten, ein Bild erzeugenden Laserstrahl erfolgen.

Die nach dem erfindungsgemässen Verfahren erhaltenen lichtvernetzten Stoffgemische können in an sich bekannter Weise als Oberflächenbeschichtungsmaterialien, zur Herstellung von Druckplatten oder gedruckten Schaltungen, als Klebstoffe, in faserverstärkten Verbundwerkstoffen, als Tauchbeschichtungsmaterialien, Fadenwicklungen und als Pressmassen zur Herstellung von Platten und Folien verwendet werden.

Erfindungsgemäss lassen sich demnach Artikel mit Oberflächenbeschichtungen, die ein nach dem erfindungsgemässen Verfahren vernetztes Produkt enthalten, oder Artikel herstellen, deren Oberflächen durch ein erfindungsgemäss vernetztes Produkt miteinander verklebt sind.

Die Erfindung wird durch die folgenden Beispiele erläutert. Alle Teile und Prozente bezüglich der Materialien bedeuten stets Gewichtsteile und -prozente.

Die in den Beispielen verwendeten lichtvernetzbaren Materialien werden wie folgt hergestellt:

Harz I

Es wird ein Gemisch aus 29,6 g 1,4-Bis[3-(4-hydroxyphenyl)-3-oxo-1-propenyl]benzol, 24,9 g 1,3-Diglycidyl-5,5-dimethylhydantoin, 0,04 g Tetraäthylammoniumbromid und 70,0 g 2-Aethoxyäthylacetat hergestellt. Dieses Gemisch wird während 2 Stunden auf 150°C erhitzt, wobei dessen Epoxidgehalt (bezogen auf die vorhandenen Feststoffe) auf 0,33 Aequivalente/kg sinkt. Das Gemisch wird auf 100°C gekühlt und mit 70,0 g Cyclohexanon versetzt. Das erhaltene Produkt,

eine Lösung eines vorverlängerten Harzes mit chalkon-artigen Gruppen in der Polymerhauptkette, wird im folgenden als Harz I bezeichnet.

Harz II

Es wird ein Gemisch aus 26,4 g 2,2-Bis (4-glycidyloxyphenyl)propan, 22,2 g 1,4-Bis[3-(4-hydroxyphenyl)-3-oxo-1-propenyl]benzol, 0,2 g Tetraäthylammoniumbromid und 48,6 g 2-Aethoxyäthylacetat hergestellt. Dieses Gemisch wird 3 Stunden auf 140°C erhitzt, wobei der Epoxidgehalt, bezogen auf den Feststoffgehalt, auf 0,45 Aequiv./kg sinkt. Das Gemisch wird auf 100°C gekühlt und mit 64,0 Cyclohexanon versetzt. Das erhaltene Produkt, eine Lösung eines vorverlängerten Harzes mit chalkon-artigen Gruppen in der Polymerhauptkette, wird im folgenden als Harz II bezeichnet.

Harz III

Harz III ist N-[2-(Methacryloyloxy)äthyl]-2,3-dimethylmaleinimid, hergestellt durch Umsetzung äquimolarer Mengen N-(2-Hydroxyäthyl)-2,3-dimethylmaleinimid und Methacryloylchlorid in Gegenwart eines geringen Ueberschusses an Triäthylamin als Säureakzeptor.

Harz IV

Es wird ein Gemisch aus 10 g Methylmethacrylat, 32,5 g Harz III, 7,5 g Methacrylsäure, 0,1 g Azobis(isobutyronitril), 100 g Aethylmetylketon und 100 g 2-Methoxyäthanol hergestellt. Dieses Gemisch wird während 24 Stunden auf 65°C erhitzt, wobei nach 17 1/2 Stunden und 21 Stunden zusätzliches Azobis(isobutyronitril) (je 0,1 g) zugesetzt wird. Das erhaltene Produkt ist eine Lösung eines Copolymers mit lichtvernetzbaren Dimethylmaleinimidgruppen und seitenständigen Carbonsäuregruppen.

Verdünner I

250 g eines im Handel erhältlichen dibromierten p-Kresylglycidyläthers (Epoxidgehalt 2,76 Aequivalente/kg) werden mit 0,5 g 2,6-Ditert-butyl-4-methylphenol und 1 g Tetramethylammoniumchlorid versetzt. Die Lösung wird unter Rühren auf 100°C erhitzt, und im Verlaufe einer Stunde werden 59,3 g Methacrylsäure so zugesetzt, dass die Temperatur des Gemisches 105°C nicht übersteigt. Die Temperatur wird weiter auf 100°C gehalten, bis der Expoxidgehalt auf einen vernachlässigbaren Wert gesunken ist. Das erhaltene Produkt ist eine klare viskose Flüssigkeit, die ein Gemisch aus am aromatischen Ring dibromierten 3-(Methacryloyloxy)-2-hydroxypropyl-p-methylphenyläthern enthält.

Die Beschleunigung der Photovernetzungsreaktion wird unter Verwendung eines Stouffer 21 Step Sensitivity Guide geprüft. Dieses Gerät hat eine Transparenz von klar bis schwarz in 21 gleichen Stufen.

Eine lichtvernetzbare Beschichtung wird während einer bestimmten Zeit durch dieses Gerät belichtet. Anschliessend wird nicht vernetztes Material durch Auswaschen mit einem geeigneten Lösungsmittel entfernt. Die Zahl der im übrig gebliebenen Bild erscheinenden Stufen ist ein Mass für die Vernetzung, die während der Belichtung stattgefunden hat. Durch die Beschleunigung der Vernetzung wird eine höhere Anzahl Stufen in dem Bild erzielt als mit einem nicht beschleunigten, während derselben Zeit belichteten Gemisch. Aus der unter Verwendung eines nicht beschleunigten Gemisches (x) erhaltenen Anzahl Stufen und dem Vergleich mit den unter Verwendung einer beschleunigten Mischung (y) erhaltenen Anzahl Stufen ergibt sich die Erhöhung der stattgefundenen Lichtvernetzung in %, gemäss folgender Formel:

$$\% \text{ Erhöhung} = \frac{(y-x)}{x} \cdot 100.$$

Beispiel 1

Harz I wird mittels Schleuderbeschichtung auf ein kupferkaschiertes Laminat appliziert und getrocknet, wobei eine etwa 10 µm dicke Schicht entsteht. Diese wird mittels einer 5000 Watt Metallhalogenidlampe in einem Abstand von 75 cm während 3 Minuten durch einen Stouffer 21 Step Sensitivity Guide belichtet. Nicht vernetztes Material wird durch Waschen mit Cyclohexanon vom Laminat entfernt, wobei ein Bild mit 6 Stufen erhalten wird.

Der Versuch wird wiederholt, wobei dem Harz I 1% 2,3-Dichlor-5,6-dicyanbenzochinon einverleibt wird. Auf dem Laminat wird ein Bild mit 10 Stufen erhalten, was einer Erhöhung der Vernetzung um 67% entspricht.

Beispiel 2

Harz II wird mittels Schleuderbeschichtung auf ein kupferkaschiertes Laminat appliziert und getrocknet, wobei eine etwa 12 µm dicke Schicht entsteht. Diese wird wie in Beispiel 1 beschrieben belichtet und in Cyclohexanon entwickelt. Dabei erhält man auf dem Laminat ein Bild mit 3 Stufen.

Wird dem Harz 1% Pyromellitsäuredianhydrid zugegeben, so erhält man ein Bild mit 9 Stufen, was einer Erhöhung der Vernetzung um 200% entspricht.

Beispiel 3

Beispiel 2 wird wiederholt, jedoch unter Einarbeitung von 1% 1,2-Dicyanbenzol in das Harz. Auf dem Laminat verbleibt ein Bild mit 9 Stufen, was einer Erhöhung der Vernetzung um 200% entspricht.

Beispiel 4

Beispiel 2 wird wiederholt, jedoch unter Einarbeitung von 1% Chloranil in das Harz. Auf dem Laminat verbleibt ein Bild mit 8 Stufen, was einer Erhöhung der Vernetzung um 167 % entspricht.

Beispiel 5

Es wird ein Gemisch aus 45 Teilen Harz III, 45 Teilen Verdünner I, 8 Teilen Benzildimethylketal und 2 Teilen 2-Chlorthioxanthon hergestellt. Mit diesem Gemisch wird mittels Schleuderbeschichtung ein kupferkaschiertes Laminat beschichtet und dann in einem Abstand von 20 cm während 10 Sekunden mit einer Mitteldruckquecksilberlampe (80 W/cm) belichtet. Dabei wird eine 30 µm dicke klebefreie Schicht erhalten.

Diese Schicht wird während 10 Minuten in einem Abstand von 75 cm mit einer 5000 Watt Metallhalogenidlampe durch einen Sensitivity Guide der oben beschriebenen Art belichtet. Unvernetztes Material wird durch Waschen in Chloroform entfernt, wobei auf dem Laminat ein Bild mit 5 Stufen zurückbleibt. Der Versuch wird wiederholt, jedoch unter Einarbeiten von 2 Teilen 1,2-Dicyanbenzol in das Gemisch. Es wird ein Bild mit 8 Stufen erhalten, was einer Erhöhung der Vernetzung um 60 % entspricht.

Beispiel 6

100 Teile Harz IV werden mit 1,6 Teilen Thioxanthon-1-carbonsäuremethylester vermischt und mittels Schleuderbeschichtung auf ein kupferkaschiertes Laminat appliziert. Das Laminat wird während 5 Minuten bei 50°C getrocknet, wobei eine 5 µm dicke Beschichtung erhalten wird. Diese wird wie in Beispiel 1 beschrieben während 2 Minuten durch einen Sensitivity Guide belichtet. Nicht vernetztes Material wird durch Waschen in einer 1%igen wässrigen Natriumcarbonatlösung entfernt. Man erhält ein Bild mit 8 Stufen. Der Versuch wird wiederholt, jedoch unter Einarbeiten von 0,4 % 1,2-Dicyanbenzol in das Gemisch. Man erhält ein Bild mit 10 Stufen, was einer Erhöhung der Vernetzung um 25% entspricht.

**Patentansprüche**

1. Lichtvernetzbare Stoffgemische, enthaltend (a) ein ungesättigtes lichtvernetzbares Material, das entweder eine Gruppe der Formel I

Ar–CH=CR–CO– (I)

welche über die angegebene Carbonylgruppe an ein C-Atom gebunden ist, oder eine Gruppe der Formel II

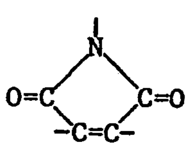

(II)

aufweist, worin

Ar eine ein-, zwei- oder dreiwertige aromatisch-carbocyclische oder aromatisch-heterocyclische Gruppe und

R ein Wasserstoffatom, eine Alkylgruppe mit 1–4 C-Atomen oder eine Gruppe darstellen, die zusammen mit dem Bindungs-C-Atom und der angegebenen Carbonylgruppe einen 5-, 6- oder 7-gliedrigen carbocyclischen oder heterocyclischen Ring bildet, und

(b) eine wirksame Menge eines organischen Elektronenakzeptors der Formel III oder IV

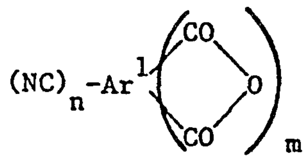

(III)

oder

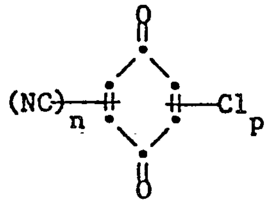

(IV)

worin

$Ar^1$ eine (2m+n)-wertige carbocyclisch-aromatische Gruppe darstellt, die durch 1 bis 4 Alkylgruppen mit 1–4 C-Atomen, Halogenatome und/oder Nitrogruppen substituiert sein kann,

n = Null oder 1 bis 4 bedeutet,

m = Null, 1 oder 2 darstellt, wobei, wenn m = 2 ist, n = Null darstellt, wenn m = 1 ist, n = 1 oder 2 darstellt und wenn m = Null ist, n = 2, 3 oder 4 darstellt und wobei die angegebenen Anhydridcarbonylgruppen an benachbarte C-Atome eines aromatischen Ringes gebunden sind, und p = Null, 2 oder 4 bedeutet, wobei die Summe von (n+p) = vier ist.

2. Stoffgemische nach Anspruch 1, worin der Elektronenakzeptor ein solcher der Formel III ist und $Ar^1$ eine monocyclische oder kondensierte polycyclische Gruppe oder eine Diarylengruppe ist, in welcher die beiden Arylengruppen je monocyclisch oder kondensiert polycyclisch sein können und über eine kovalente Bindung, ein Sauerstoffatom, eine Carbonyl-, Sulfonyl- oder Alkylengruppe mit 1–6 C-Atomen miteinander verknüpft sind.

3. Stoffgemische nach Anspruch 2, worin $Ar^1$ ein Benzolring, ein Naphthalinring, eine Diphenylengruppe oder eine Benzophenongruppe ist.

4. Stoffgemische nach Anspruch 1, worin der Elektronenakzeptor 1,2-,1,3- oder 1,4-Dicyanbenzol, 1,2,4,5-Tetracyanbenzol, Pyromellitsäuredianhydrid, 3,4,3',4'-Benzophenontetracarbonsäuredianhydrid, 2,3-Dichlor-5,6-dicyanbenzochinon oder Chloranil ist.

5. Stoffgemische nach einem der Ansprüche 1–4, welche den Elektronenakzeptor in einer Menge von 0,1 bis 6 Gew.%, bezogen auf das Gewicht des lichtvernetzbaren Materials, enthalten.

6. Stoffgemische nach einem der Ansprüche 1–5, worin das lichtvernetzbare Material entweder eine Gruppe der Formel I, worin Ar eine ein- oder zweiwertige mono- oder bicyclische aromatische Kohlenwasserstoffgruppe mit 6–10 C-Atomen oder eine mono- oder bicyclische aromatisch-heterocyclische Gruppe mit 4–9 C-Atomen und R ein Wasserstoffatom bedeuten, oder eine Gruppe der Formel II ist, worin die äthylenischen Kohlenstoffatome direkt an ein Wasserstoff- oder Halogenatom oder an eine Alkylgruppe mit

1-4 C-Atomen, eine Cyan- oder Phenylgruppe gebunden sind.

7. Stoffgemische nach Anspruch 6, worin das lichtvernetzbare Material eine Gruppe der Formel II, die Bestandteil einer Maleinimidstruktur ist, enthält.

8. Stoffgemische nach Anspruch 6 oder 7, worin das lichtvernetzbare Material ein Epoxidharz mit durchschnittlich mehr als einer Gruppe der Formel I, N-(2-Acryloyloxyäthyl)-2,3-dimethylmaleinimid, N-(2-Methacryloyloxyäthyl)-2,3-dimethylmaleinimid, ein Homopolymer der genannten Acryloyloxy- oder Methacryloyloxyverbindung oder ein Copolymer davon mit einem Vinylmonomer ist.

9. Verfahren zur Herstellung von lichtvernetzten Produkten, dadurch gekennzeichnet, dass man ein Stoffgemisch gemäss einem der Ansprüche 1-8 herstellt und das Stoffgemisch bis zur Vernetzung mit aktinischem Licht bestrahlt.

10. Verfahren nach Anspruch 9, dadurch gekennzeichnet, dass man aktinisches Licht mit einer Wellenlänge von 200-600 nm verwendet.

11. Verwendung von Stoffgemischen nach einem der Ansprüche 1-8 zur Bilderzeugung.

## Claims

1. Photocrosslinkable compositions comprising (a) an unsaturated photocrosslinkable material that contains either a group of the formula I

$$Ar-CH=CR-CO- \qquad (I)$$

attached through the indicated carbonyl group to a carbon atom, or a group of the formula II

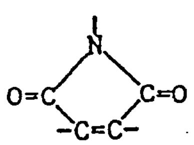

II

wherein

Ar represents a mono-, di- or trivalent aromatic carbocyclic or heterocyclic group, and

R represents a hydrogen atom, an alkyl group of 1 to 4 carbon atoms, or a group which, together with the attached carbon atom and the indicated carbonyl group, forms a 5-, 6-, or 7-membered carbocyclic or heterocyclic ring, and

(b) an effective amount of an organic electron acceptor which is of the formula III or IV

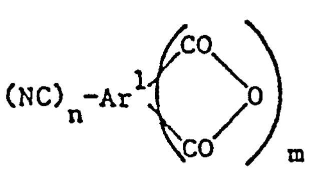

III

or

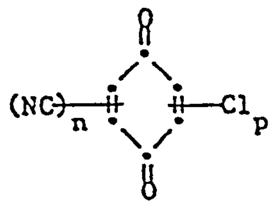

IV

wherein

$Ar^1$ represents a (2m+n)-valent carbocyclic aromatic group, which may be substituted by 1 to 4 alkyl groups of 1 to 4 carbon atoms, halogen atoms and/or nitro groups,

n denotes zero or 1 to 4,

m represents zero, 1 or 2 such that when m is 2, n represents zero,

when m is 1, n represents 1 or 2, and when m is zero, n represents 2, 3, or 4, the indicated anhydride carbonyl groups being attached to vicinal carbon atoms of an aromatic ring, and

p denotes zero, 2 or 4, such that the sum of (n+p) is 4.

2. Compositions according to Claim 1, in which the electron acceptor is of the formula III and $Ar^1$ is a monocyclic or condensed polycyclic group, or a diarylene group, in which the two arylene groups can each be monocyclic or condensed polycyclic and are linked with each other by a covalent bond, by an oxygen atom, or by a carbonyl, sulfonyl or alkylene group of 1 to 6 carbon atoms.

3. Compositions according to Claim 2, in which $Ar^1$ is a benzene ring, a naphthalene ring, a diphenylene group or a benzophenone group.

4. Compositions according to Claim 1, in which the electron acceptor is 1,2-, 1,3-, or 1,4-dicyanobenzene or 1,2,4,5-tetracyanobenzene, pyromellitic dianhydride, 3,4,3′,4′-benzophenonetetracarboxylic dianhydride, 2,3-dichloro-5,6-dicyanobenzoquinone or chloranil.

5. Compositions according to one of Claims 1-4, which contain 0.1 to 6% by weight of the electron acceptor, calculated on the weight of the photocrosslinkable material.

6. Compositions according to one of Claims 1-5, in which the photocrosslinkable material is either a group of the formula I in which Ar denotes a mono- or divalent, mono- or bicyclic aromatic hydrocarbon group of from 6 to 10 carbon atoms or a mono- or bicyclic aromatic heterocyclic group of 4 to 9 carbon atoms, and R denotes a hydrogen atom, or a group of the formula II, in which the ethylenic carbon atoms are directly attached to a hydrogen or halogen atom, an alkyl group of 1 to 4 carbon atoms, a cyano group or a phenyl group.

7. Compositions according to Claim 6, in which the photocrosslinkable material contains a group of the formula II which is part of a maleimide structure.

8. Compositions according to Claim 6 or 7, in which the photocrosslinkable material is an epoxide resin containing on average more than one group of the formula I, N-(2-acryloyloxyethyl)-2,3-dimethylmaleimide, N-(2-methacryl-

oyloxyethyl)-2,3-dimethylmaleimide, a homopolymer of the above acryloyloxy or methacryloyloxy compound or a copolymer thereof with a vinyl monomer.

9. Process for the preparation of photocrosslinked products, characterized in that a composition as claimed in one of Claims 1-8 is prepared, and the composition is irradiated with actinic light until it is crosslinked.

10. Process according to Claim 9, characterized in that actinic light with a wavelength of 200-600 nm used.

11. Use of compositions according to Claims 1-8 for image formation.

## Revendications

1. Mélanges photoréticulables qui renferment:

(a) une matière insaturée photoréticulable qui contient soit un radical de formule I:

Ar-CH=CR-CO- (I)

relié à un atome de carbone par le radical carbonyle représenté, soit un radical de formule II:

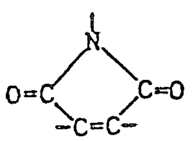

(II)

les symboles présents dans la formule I ayant les significations suivantes:

Ar représente un radical aromatique-carbocyclique ou aromatique-hétérocyclique univalent, divalent ou trivalent et

R représente un atome d'hydrogène, un radical alkyle contenant de 1 à 4 atomes de carbone ou un radical qui forme, avec l'atome de carbone de liaison et le radical carbonyle représenté, un noyau carbocyclique ou hétérocyclique renfermant 5, 6 ou 7 maillons, et

(b) une quantité efficace d'un accepteur d'électrons organique répondant à l'une des formules III et IV

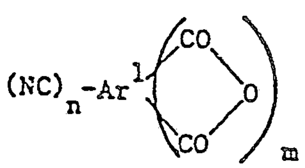

(III)

et

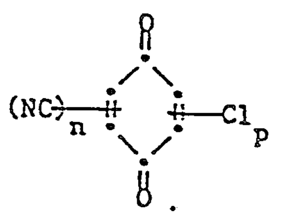

(IV)

dans lesquelles:

$Ar^1$ représente un radical carbocyclique-aromatique de valence égale à (2m +n), radical qui peut porter de 1 à 4 alkyles en $C_1$-$C_4$, des atomes d'halogènes et/ou des radicaux nitro,

n désigne un nombre de 0 à 4,

m désigne un nombre égal à 0, à 1 ou à 2, avec les conditions suivantes:

- lorsque m est égal à 2, n est égal à 0,
- lorsque m est égal à 1, n est égal à 1 ou à 2 et
- lorsque m est égal à 0, n est égal à 2,

à 3 ou a 4,

les radicaux carbonyles de la fonction anhydride représentée étant liés à des atomes de carbone voisins du cycle aromatique, et

p est égal 0, à 2 ou à 4, la somme (n + p) étant égale à 4.

2. Mélanges selon la revendication 1 dans lesquels l'accepteur d'électrons est un composé de formule III dans lequel $Ar^1$ représente un radical monocyclique, un radical polycyclique condensé ou un radical de diaryle dans lequel les deux radicaux aryles peuvent être chacun monocycliques ou à noyaux condensés et sont reliés l'un à l'autre par une liaison de covalence, par un atome d'oxygène, par un radical carbonyle ou sulfonyle ou par un radical alkylène contenant de 1 à 6 atomes de carbone.

3. Mélanges selon la revendication 2 dans lesquels $Ar^1$ représente un noyau benzénique, un noyau naphtalénique, un radical de biphényle ou un radical de benzophénone.

4. Mélanges selon la revendication 1 dans lesquels l'accepteur d'électrons est le dicyano-1,2, -1,3 ou -1,4 benzène, le tétracyano-1,2,4,5 benzène, le dianhydride de l'acide pyromellitique, le dianhydride de l'acide benzophénone-tétracarboxylique-3,4,3',4', la dichloro-2,3 dicyano-5,6 benzoquinone ou le chloranile.

5. Mélanges selon l'une quelconque des revendications 1 à 4, mélanges qui contiennent l'accepteur d'électrons en une quantité de 0,1 à 6% en poids par rapport au poids de la matière photoréticulable.

6. Mélanges selon l'une quelconque des revendications 1 à 5, mélanges dans lesquels la matière photoréticulable contient soit un radical de formule I dans lequel Ar représente un radical hydrocarboné aromatique monocyclique ou bicyclique, univalent ou divalent, contenant de 6 à 10 atomes de carbone, ou un radical aromatique-hétérocyclique, monocyclique ou bicyclique, contenant de 4 à 9 atomes de carbone, et R représente un atome d'hydrogène, soit un radical de formule II dans lequel les atomes de carbone éthyléniques sont liés directement à un atome d'hydrogène ou d'halogène ou à un radical alkyle contenant de 1 à 4 atomes de carbone, à un radical cyano ou à un radical phényle.

7. Mélanges selon la revendication 6 dans lesquels la matière photoréticulable contient un radical de formule II qui fait partie d'une structure maléimidique.

8. Mélanges selon l'une des revendications 6 et 7, dans lesquels la matière photoréticulable est une résine époxydique renfermant en moyenne plus d'un radical de formule I, le N-(acryloyloxy-2

éthyl) diméthyl-2,3 maléimide, le N-(méthacryloyloxy-2 éthyl) diméthyl-2,3 maléimide, un homopolymère des composés acryloyloxy et méthacryloyloxy qui viennent d'etre cités, ou un copolymère de ceux-ci avec un monomère vinylique.

9. Procédé de préparation de produits photoréticulés, procédé caractérisé en ce qu'on prépare un mélange selon l'une quelconque des revendications 1 à 8 et on expose ce mélange à un rayonnement actinique jusqu'à ce que la réticulation ait eu lieu.

10. Procédé selon la revendication 9 caractérisé en ce qu'on utilise un rayonnement actinique d'une longueur d'onde comprise entre 200 et 600 nm.

11. Application de mélanges selon l'une quelconque des revendications 1 à 8 pour la production d'images.